# EUROPEAN PATENT SPECIFICATION

(11) **EP 0 563 925 B1**
(45) Date of publication and mention of the grant of the patent: **02.02.2000**
(21) Application number: 93105347.4
(22) Date of filing: 31.03.1993
(51) Int. Cl.: G03F 7/029, C08F 2/50

(54) **Photopolymerizable composition**
Photopolymerisierbare Zusammensetzung
Composition photopolymérisable

(30) Priority: 01.04.1992 JP 7987992
(43) Date of publication of application: 06.10.1993
(73) Proprietor: FUJI PHOTO FILM CO., LTD., Kanagawa-ken, 250-01 (JP)
(72) Inventor: Okamoto, Yasuo, c/o Fuji Photo Film Co., Ltd., Haibara-gun, Shizuoka-ken (JP); Kondo, Syunichi, c/o Fuji Photo Film Co., Ltd., Haibara-gun, Shizuoka-ken (JP); Kawamura, Kouichi, c/o Fuji Photo Film Co., Ltd., Haibara-gun, Shizuoka-ken (JP); Kurita, Hiromichi, c/o Fuji Photo Film Co., Ltd., Haibara-gun, Shizuoka-ken (JP)
(74) Representative: Grünecker, Kinkeldey, Stockmair & Schwanhäusser Anwaltssozietät

(56) References cited:
- EP-A- 0 369 645
- EP-A- 0 377 321
- EP-A- 0 379 200

## Description

The present invention relates to a photopolymerizable composition and more specifically to a photopolymerizable composition comprising a polymerizable compound having an addition-polymerizable unsaturated bond, a photopolymerization initiator comprising a novel composition and an optional linear organic polymer, which can be responsive to light from, for example, an Ar laser and is useful for light-sensitive layers of presensitized plates.

Methods of duplicating images by photographical techniques using a light-sensitive composition comprising a blend of a polymerizable compound having an addition-polymerizable unsaturated bond, a photopolymerization initiator, an optional suitable film-forming binder and an optional thermal polymerization inhibitor are known in the prior art. For example, United States Patent (hereinafter referred to as "U.S.P.") Nos.2,927,022, 2,902,356 and 3,870,524 disclose some embodiments thereof. As disclosed in these patents, since this type of light-sensitive composition is photopolymerized by irradiation of light so that it is cured and insolubilized, images can be formed by preparing a suitable film of the light-sensitive composition, imagewise exposing the film to light through a desired negative original and removing the unexposed areas with a suitable solvent (hereinafter referred to as "development") to form desired images comprising the cured photopolymerizable composition. It is a matter of course that this type of light-sensitive composition is extremely useful for a material for preparing printing plates.

In addition, there has been proposed the addition of photopolymerization initiators for improving the insufficient light-sensitivities of polymerizable compound having an addition-polymerizable unsaturated bond. As such photopolymerization initiator, e.g. benzoyl, benzoin, benzoin ethyl ether, Michler's ketone, anthraquinone, acridine, phenazine, benzophenone and 2-ethyl anthraquinone have been used. EP-A-379200 discloses the use of a photopolymerization initiator system comprising a squarylium dye, and a triazine compound having at least one halogenated methyl group. However, even if these photopolymerization initiators are used in photopolymerizable compositions, a long period of time is required for the imagewise exposure to light in imaging processes since the sensitivities of the photopolymerizable compositions are low. For this reason, when the minute original is duplicated, slight vibration during the operation causes insufficient image reproduction and increased energy irradiation dose of light source is required for the exposure to light so that the problem of dispersion of enormous heat generation from the light source has to be taken into consideration. In addition, there has been a problem that shapes and properties of the composition film is easily changed.

Furthermore, there have been recently studied methods of improving the sensitivity to ultraviolet and methods of forming images using laser. As a result, UV projection exposure methods for the preparation of printing plates, laser direct plate making, laser facsimile, holography and the like have been put in to practical use. Although light-sensitive materials therefor having high sensitivities have been desired and developed, there have not been found light-sensitive materials having sufficient sensitivities.

Accordingly, an object of the present invention is to provide a photopolymerizable composition having high sensitivity. Namely, the object of the present invention is generally to provide a photopolymerizable composition comprising a photopolymerization initiator which increases the photopolymerization rate of the photopolymerizable composition comprising a photopolymerizable compound having an addition-polymerizable unsaturated bond and has high sensitivity to visible light having a wavelength of 400 nanometers and more, especially light having a wavelength around 488 nanometers which corresponds to the output irradiation of an Ar ⁺ laser.

The inventors of this invention have conducted various studies to accomplish the foregoing objects, have found that specific polymerization initiator systems can extremely increase the photopolymerization rates of polymerizable compounds having an addition-polymerizable unsaturated bond and have high sensitivities to visible light having a wavelength of 400 nanometers and more, and thus have completed the present invention.

According to the present invention, there is provided a photopolymerizable composition comprising the following compounds (i), (ii) and (iii), and the following optional compound (iv):
(i) a polymerizable compound having an addition-polymerizable unsaturated bond,
(ii) a sensitizing compound capable of absorbing radiation somewhere within the range of wavelengths between 250 and 1000 nanometers and capable of sensitizing 2-phenyl-4,6-bis(trichloromethyl)-s-triazine,
(iii) a 2,4,6-substituted-1,3,5-triazine compound represented by formula (I) 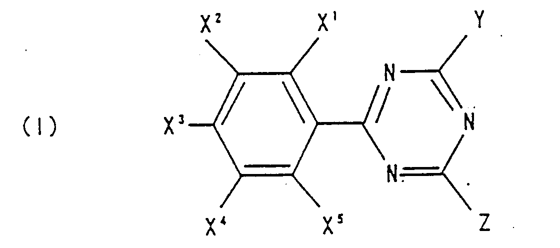 wherein Y and Z are the same or different, and each is an alkyl, substituted alkyl, aryl, substituted aryl, aralkyl or substituted aralkyl group, provided that at least one of them is a mono-, di-, or trihalogen-substituted methyl group,
   X¹-X⁵ each is a hydrogen atom or a group having a Hammet's σₘ value of more than 0.40, provided that at least one of them is not a hydrogen atom;
(iv) a compound selected from the group consisting of:
   (a) compounds having a group of R¹ R² N-
      wherein R¹ and R² each ist a hydrogen atom, an alkyl group having from 1 to 18 carbon atoms or a substituted alkyl group having from 1 to 18 carbon atoms with a substituent selected from -OR³, -CO-R³, -CO-C₆H₄-(B)ₙ, -COOR³, -NH-CO-R³, -NH-CO-C₆H₄-(B)ₙ, -(CH₂CH₂O)ₘ-R³ and a halogen atom,
      such as F, Cl, Br and I, wherein R³ is a hydrogen atom or an alkyl group having from 1 to 10 carbon atoms and B is a dialkyl amino group, a hydroxyl group, an acyloxy group, a halogen atom or a nitro group,
      n is an integer of from 0 to 4, and m is an integer of from 1 to 20;
   (b) thio compounds represented by the following general formula (III) 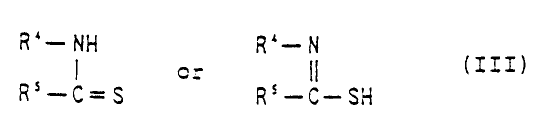 wherein R⁴ is an alkyl group, a substituted alkyl group, an aryl group or a substituted aryl group, R⁵ is a hydrogen atom, an alkyl group, or a substituted alkyl group, and R⁴ and R⁵ may be bonded together to form a non-metal atom group necessery for forming a 5 -7 membered ring which may contain a hetero atom selected from oxygen, sulfur and nitrogen atoms,
   (c) compounds represented by the following general formula (IV) 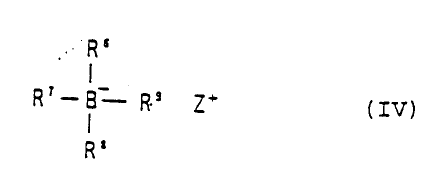 wherein R⁶, R⁷, R⁸ and R⁹ are the same or different, and each is a substituted or unsubstituted alkyl group, a substituted or unsubstituted aryl group, a substituted or unsubstituted alkenyl group, a substituted or unsubstituted alkynyl group, a substituted or unsubstituted heterocyclic group, and at least two of R⁶, R⁷, R⁸ and R⁹ may be bonded together to form a cyclic structure, provided that at least one of R⁶, R⁷, R⁸ and R⁹ is an alkyl group, and Z⁺ represents an alkaline metal cation or a quaternary ammonium cation.

Each component of the photopolymerizable composition of the present invention will be hereinafter explained in detail.

The polymerizable compound having an addition-polymerizable unsaturated bond as component (i) used in the present invention can be selected from compounds having at least one, preferably two terminal ethylenically unsaturated bonds. Component (i) may be a compound having a chemical structure such as a monomer, a prepolymer including a dimer, trimer, and oligomer, mixtures thereof, and copolymers thereof. Examples of the monomers and the copolymers thereof include esters of unsaturated caboxylic acids such as acrylic acid, methacrylic acid, itaconic acid, crotonic acid, isocrotonic acid and maleic acid with aliphatic polyhydric alcohol compounds or amides of aliphatic polyvalent amine compounds with unsaturated carboxylic acids.

Specific examples of the monomeric esters of the aliphatic polyhydric alcohols with the unsaturated caboxylic acids include acrylates such as ethylene glycol diacrylate, triethylene glycol diacrylate, 1,3-butanediol diacrylate, tetramethylene glycol diacrylate, propylene glycol diacrylate, neopentyl glycol diacrylate, trimetylolpropane triacrylate, trimetylolpropane tri(acryloyl oxypropyl) ether, trimetylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloly oxyethyl) isocyanurate and polyester acrylate oligomers;
methacrylates such as tetramethylene glycol dimethacrylate, triethylene glycol dimethacrylate, neopentyl glycol dimethacrylate, trimetylolpropane trimethacrylate, trimetylolothane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy) phenyl] dimethylmethane and bis[p-(acryloxy ethoxy)phenyl] dimethylmethane;
itaconates such as ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetramethacrylate;
crotonates such as ethylene glycol dicrotonate, tetramethylene glycol dicrotonate, pentaerythritol dicrotonate and sorbitol tetradicrotonate;
isocrotonates such as ethylene glycol diisocrotonate, pentaerythritol diisocrotonate and sorbitol tetraisocrotonate;
maleates such as ethylene glycol dimaleate, triethylene glycol dimaleate, pentaerythritol dimaleate and sorbitol tetramaleate; and mixtures thereof.

Specific examples of the monomeric amides of the aliphatic polyvalent amine compounds with the unsaturated carboxylic acids include e.g methylene bis-acrylamide, methylene bis-methacrylamide, 1,6-hexamethylene bis-acrylamide, 1,6-hexamethylene bis-methacrylamide, diethylene triamine trisacrylamide and xylylene bismethacryl amide.

The other examples of component (i) include vinyl urethane compounds having at least two polymerizable vinyl groups in the molecule, which are obtained by adding vinyl monomers having a hydroxyl group represented by the following general formula (A) to polyisocyanate compounds having at least two isocyanate groups in the molecule as disclosed in Japanese patent examined publication (hereinafter referred to as "J.P.KOKOKU") No. Sho 48-41708.

CH₂=C(R)COOCH₂CH(R')OH (A)

wherein R and R' each is H or CH₃.

Furthermore, urethane acrylates as disclosed in Japanese patent unexamined publication (hereinafter referred to as "J.P.KOKAI") No. Sho 51-37193, polyester acrylates as disclosed in J.P.KOKAI No. Sho 48-64183, J.P.KOKOKU Nos. 49-43191 and Sho 52-30490, polyfunctional acrylates and methacrylates such as epoxy acrylates which are obtained by reacting epoxy resins with (meth)acrylic acid and photo-curable monomers and oligomers disclosed in Journal of Japan Adhesion Society vol. 20, No. 7, pp.300-308 (1984)) can be used. The amount of component (i) is from 5 to 50 % by weight (hereinafter abbreviated to "%"), preferably from 10 to 40 % based on the total weight of the photopolymerizable composition.

Specific examples of the sensitizing compounds of component (ii) include cyanine dyes, merocyanine dyes, coumarin dyes, ketocoumarin dyes, (thio)xanthene dyes, acridine dyes, thiazole dyes, thiazine dyes, oxazine dyes, azine dyes, aminoketone dyes, squarylium dyes, pyridinium dyes, (thia)pyrylium dyes, porphyrin dyes, triaryl methane dyes, (poly)methine dyes, amino styryl compounds and aromatic polycyclic hydrocarbons. Among them, cyanine dyes, merocyanine dyes, ketocoumarin dyes, (thio) xanthene dyes, (poly)methine dyes, (thia)pyrylium dyes, amino styryl compounds are preferred sensitizing compounds.

Specific examples of these dyes include cyanine dyes disclosed in J.P.KOKAI No. Sho 64-13140, merocyanine dyes disclosed in J.P.KOKAI Nos. Sho 59-89303, Hei 2-244050 and U.S.Pat.No. 5049481, ketocoumarin dyes disclosed in Polymer. Eng. Sci.,23, 1022 (1983) and J.P.KOKAI No. Sho 63-178105, (thio) xanthene dyes disclosed in J.P.KOKAI Nos. Sho 64-13140 and U.S.Pat.No. 4939069, (poly)methine dyes disclosed in EP 520364A, (thia)pyrylium dyes disclosed in J.P.KOKAI Nos. Sho 58-40302 and Hei 1-100536, and amino styryl compounds disclosed in J.P.KOKAI Nos. Sho 55-50001, Hei 2-69, Hei 2-63053 and Hei 2-229802.

Representative examples of these dyes include the following compounds.

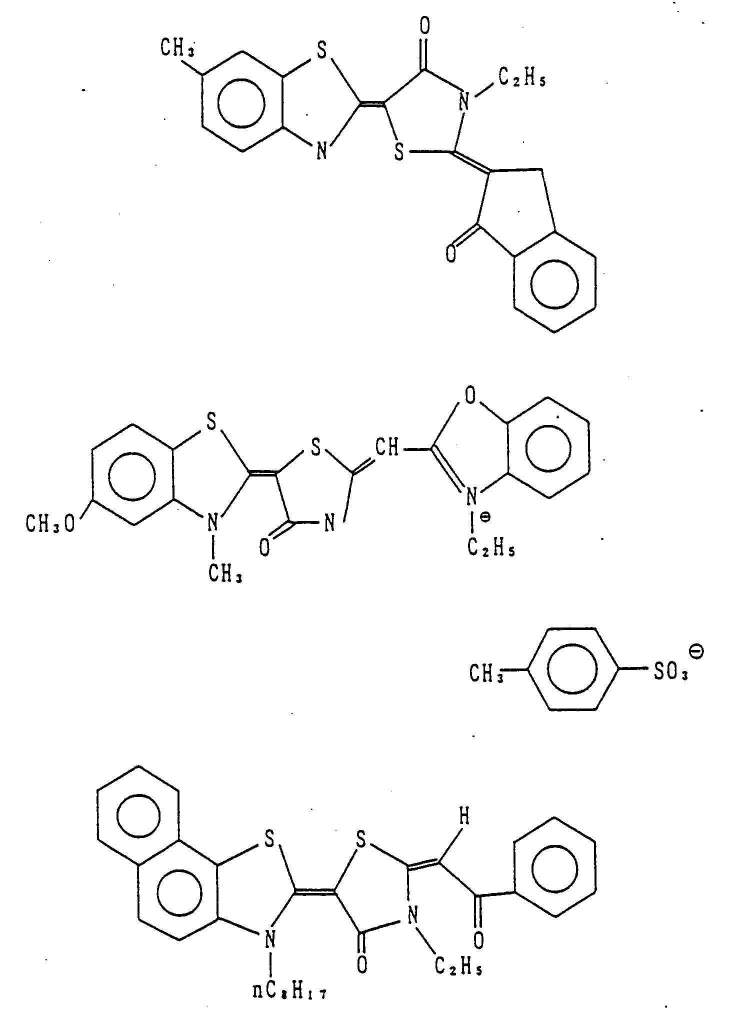

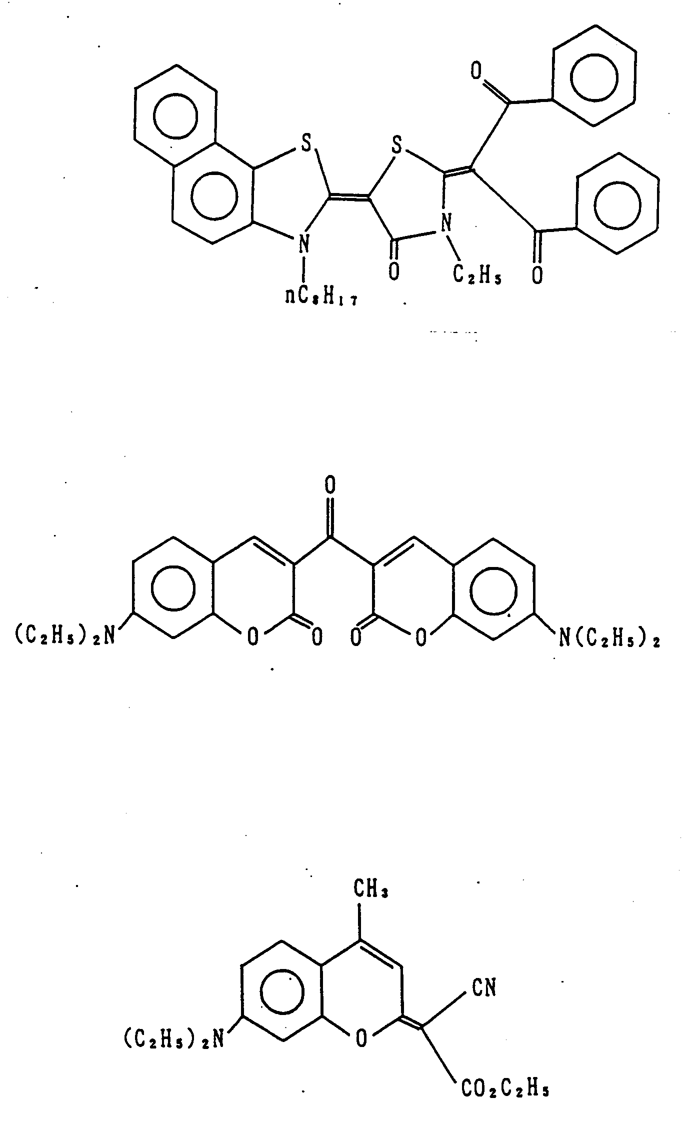

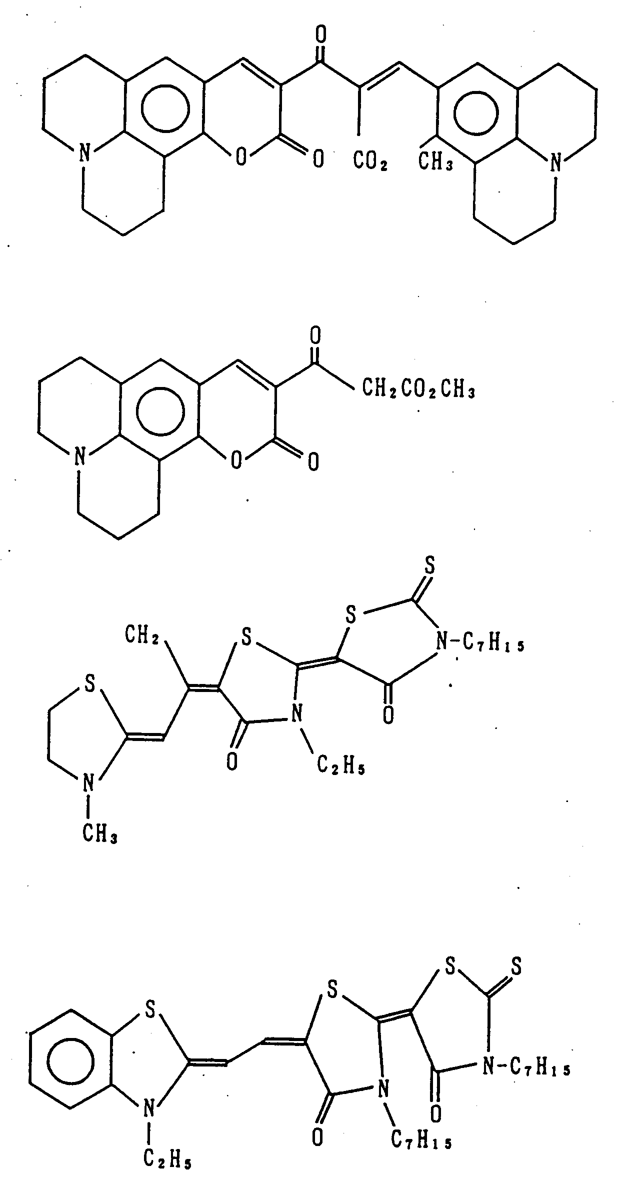

Specific examples of 2,4,6-substituted-1,3,5-triazine compounds represented by formula (I) of component (iii) include the following compounds.

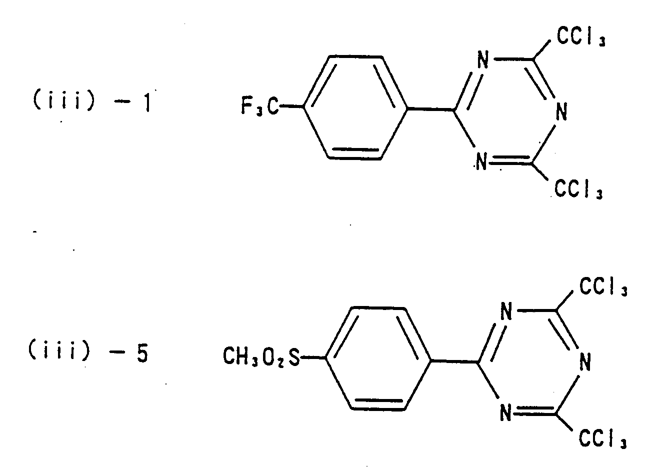

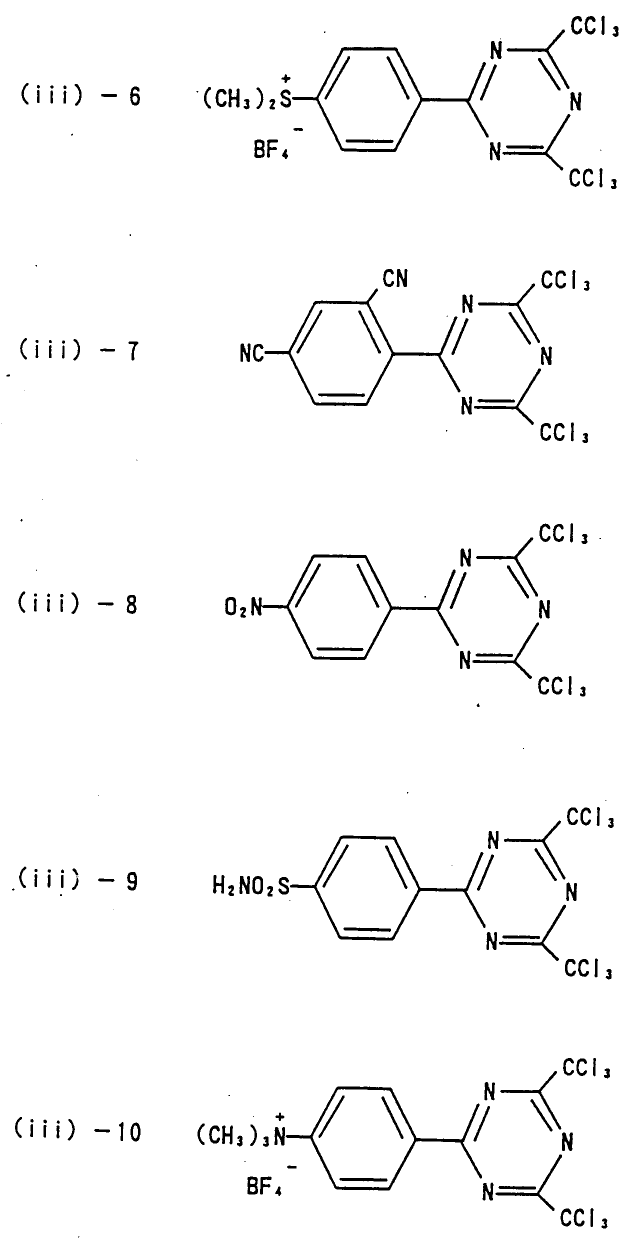

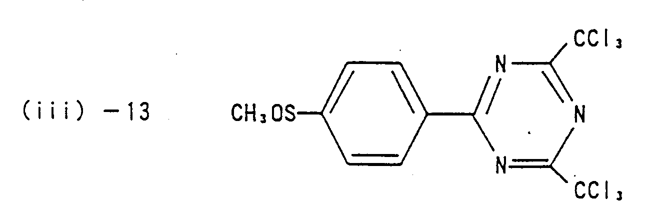

Specific examples of compounds (a) as members of component (iv) include various types of amines. Specific examples of compounds (a) include the following compounds.

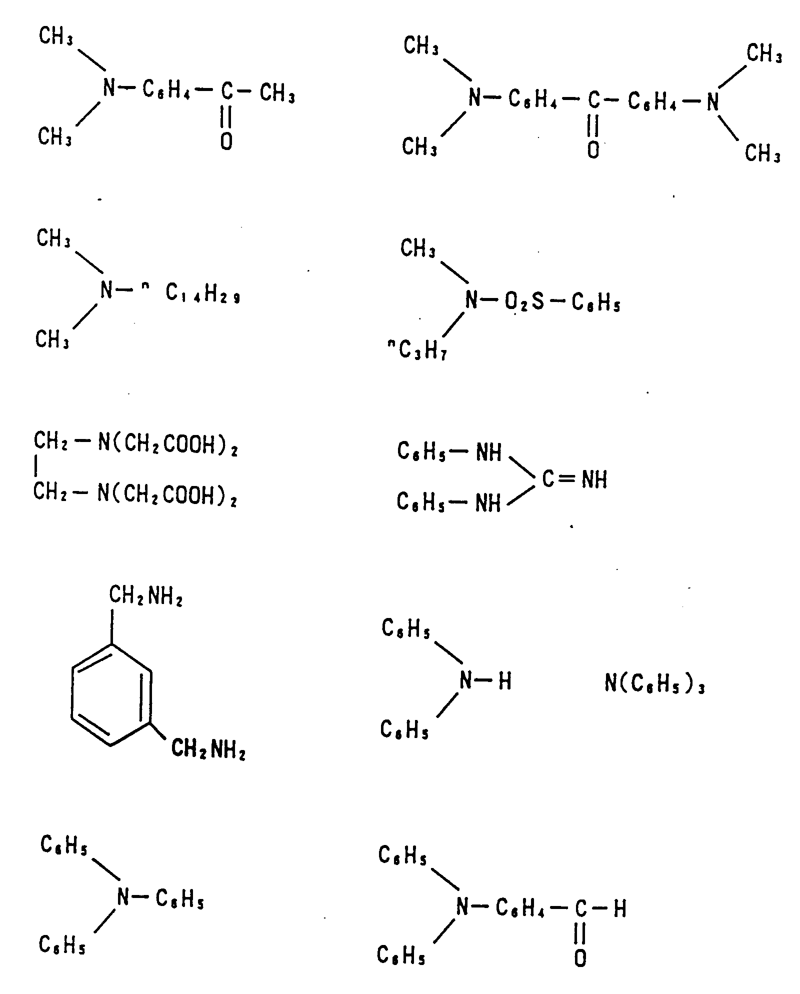

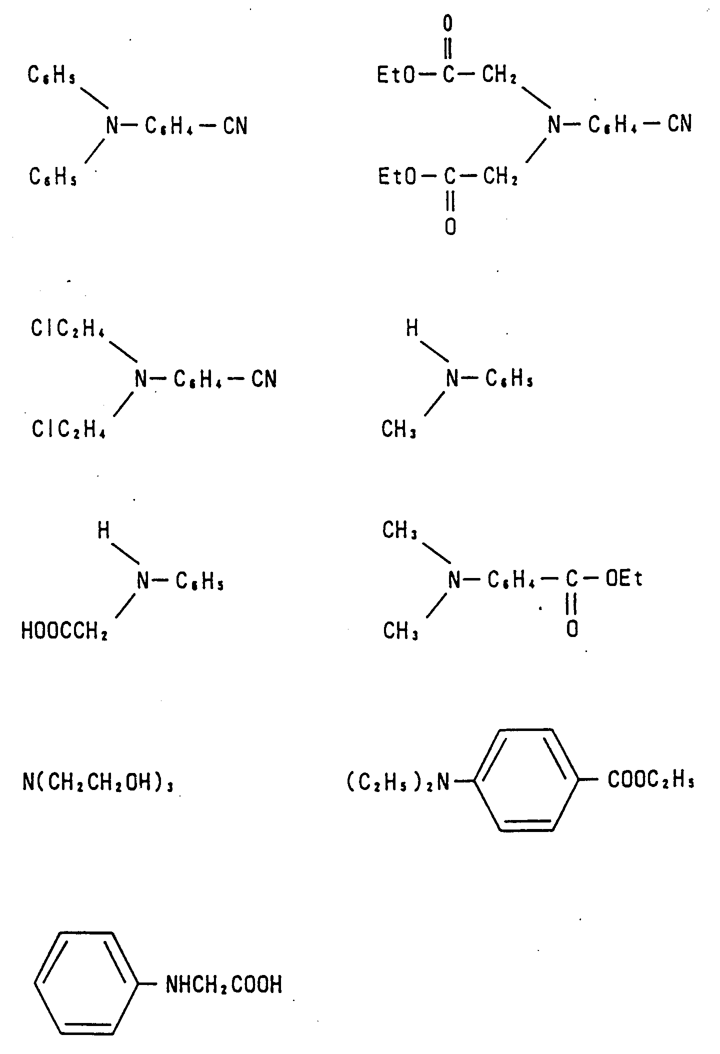

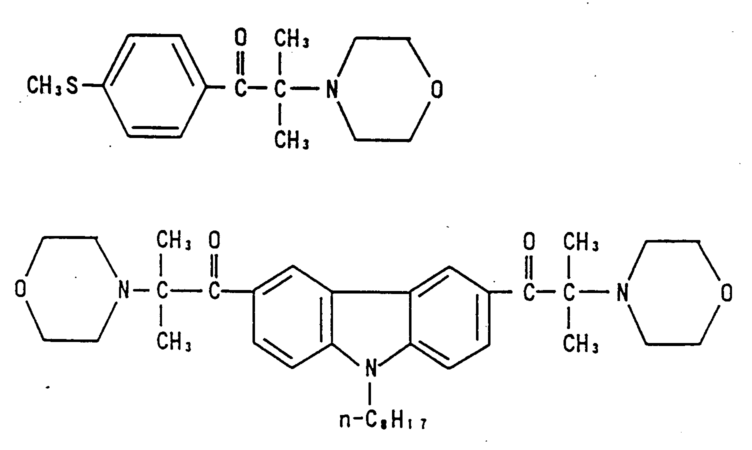

Specific examples of thio compounds (b) represented by general formula (III) include compounds having substituents R⁴ and R⁵ shown in the following table 1. In compounds 15-45, the groups shown in Table 1 are those formed by combining R⁴ and R⁵.

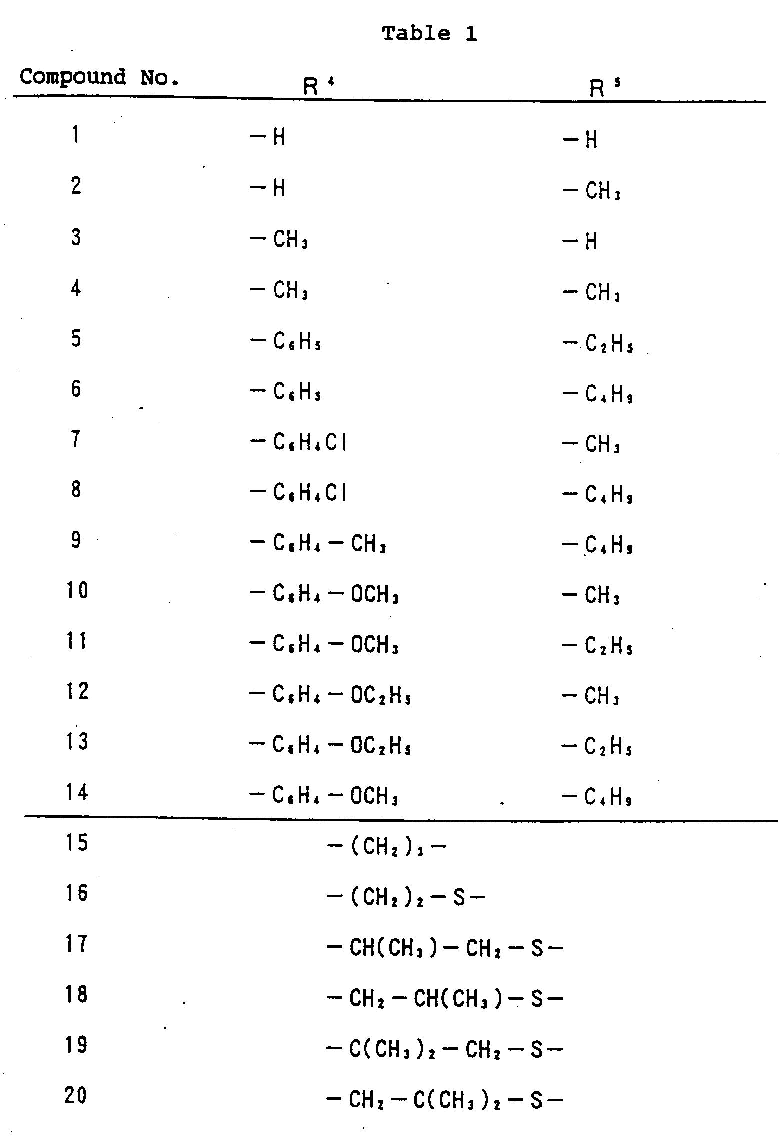

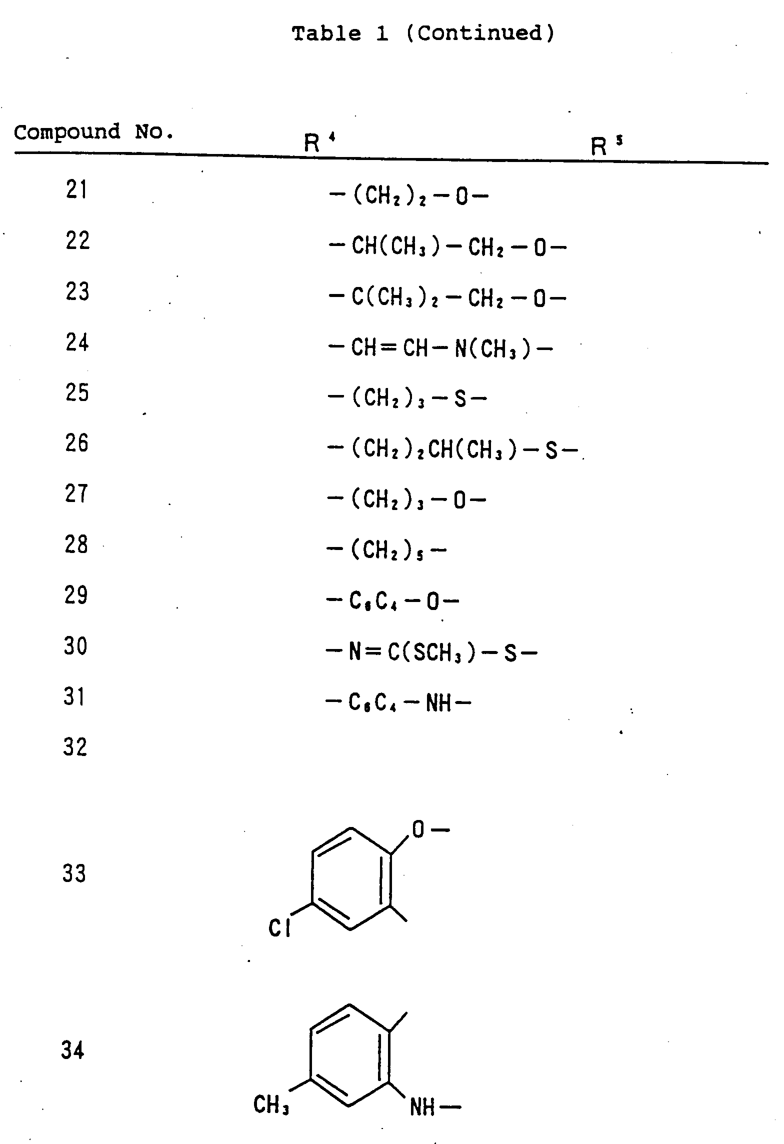

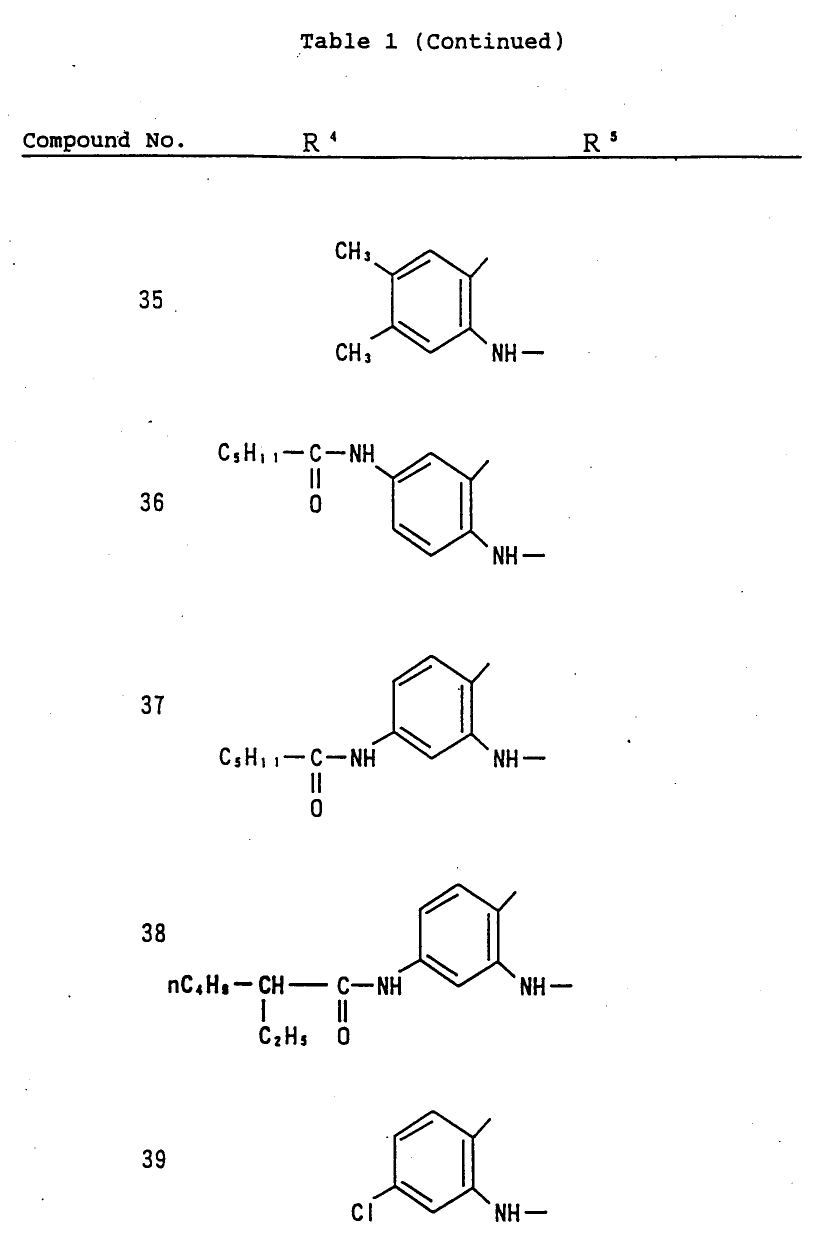

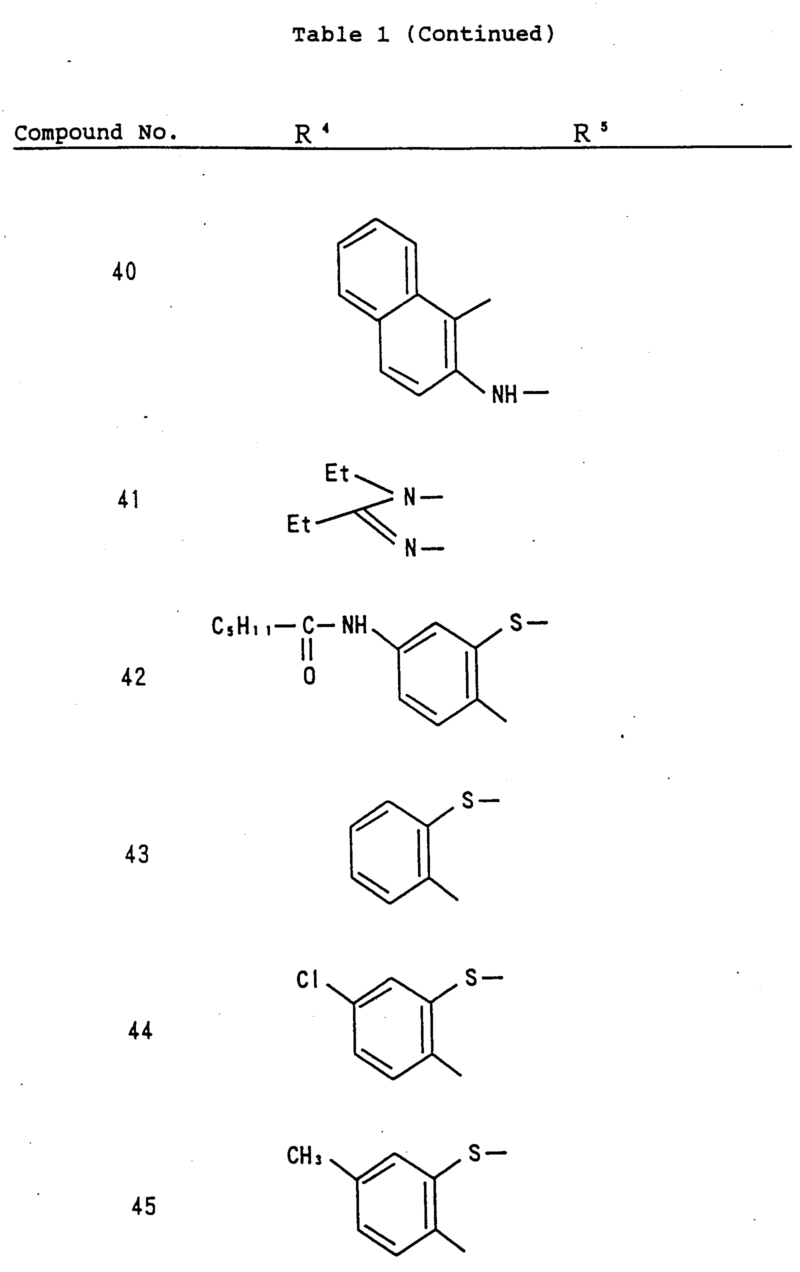

Specific examples of compounds (c) include compounds disclosed in J.P.KOKAI No. Hei 2-179643.

The photopolymerizable composition of the present invention preferably contains a linear organic polymer. Any linear organic polymers can be used if they are compatible with the polymerizable compound having an addition-polymerizable unsaturated bond. Linear organic polymers which are soluble in or swellable with water or weakly alkaline water and thus can be developed with water or weakly alkaline water are preferably selected. The linear organic polymer is suitably selected depending on not only the use as a film-forming agent for the photopolymerizable composition but also the kind of developer such as water, weakly alkaline water or an organic solvent. For example, if a water-solulble organic polymer is used, the light-sensitive material containing such a polymer can be developed with water. Examples of the linear organic polymers include addition polymers having carboxyl groups in the side chains such as methacrylic copolymers, acrylic copolymers, copolymers of itaconic acid, copolymers of crotonic acid, copolymers of maleic acid and copolymers of partially esterified maleic acid, as disclosed in J.P.KOKAI Nos. Sho 59-44615, 54-92723, 59-53836 and 59-71048, and J.P.KOKOKU Nos. 54-34327, 58-12577 and 54-25957, and acidic cellulose derivatives having carboxyl groups in the side chains. In addition, polymers which are obtained by adding cyclic acid anhydrides to addition polymers having a hydroxyl group can be used. Among them, [benzyl (meth)acrylate/(meth)acrylic acid/the other optional addition-polymerizable vinyl monomer]copolymers are preferred. As water-soluble linear organic polymers, polyvinyl pyrrolidone and polyethylene oxide can be used. For improving the strength of the cured films, alcohol-soluble polyamide and polyether of 2,2-bis-(4-hydroxyphenyl)-propane with epichlorohydrin can be used. These linear organic polymers can be contained in the photopolymerizable composition in any suitable amounts. However, if the amount of the linear organic polymer is more than 90 % undesired image strength may be obtained. The amount of the linear organic polymer is preferably from 30 to 85 % . The ratio of the polymerizable compound having an addition-polymerizable unsaturated bond to the linear organic polymer is preferably from 1/9 to 7/3, more preferably from 3/7 to 5/5 by weight.

A slight amount of the photopolymerization initiator system is generally contained in the photopolymerizable composition of the present invention. If an unsuitably large amount of the photopolymerization initiator is contained in the composition, undesired results such as the cut-off of effective light may be obtained. The amount of the photopolymerization initiator system is preferably from 0.01 to 60 %, more preferably from 1 to 30 % based on the sum of the weight of the polymerizable compound having an addition-polymerizable unsaturated bond and the weight of the optionally added linear organic polymer.

The ratio of component (iii) to component (ii) is preferably from 0.05 to 30 parts by weight, more preferably from 0.1 to 10 parts by weight, most preferably from 0.2 to 5 parts by weight of component (ii) based on one part by weight of component (ii).

When component (iv) is added, the ratio of component (iv) to component (iii) is from 0.05 to 50, more preferably from 0.1 to 30, most preferably from 0.2 to 10 parts by weight of component (iv) based on one part by weight of component (iii).

In addition to the above essential components, a small amount of a thermal polymerization inhibitor is desirably added to the photopolymerizable composition of the present invention for inhibiting the undesired thermal polymerization of the polymerizable compound having an addition-polymerizable unsaturated bond during the preparation or the storage of the photopolymerizable composition. Examples of the suitable thermal polymerization inhibitors include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylene bis(4-methyl-6-t-butylphenol), N-nitrosophenyl hydroxylamine cerium salt and N-nitrosophenyl hydroxylamine aluminum salt. The amount of the thermal polymerization inhibitor is preferably from about 0.01 to about 5 % based on the total weight of the photopolymerizable composition. In addition, for preventing the inhibition of the polymerization caused with oxygen, higher fatty acid derivatives such as behenic acid and behenic acid amide may be optionally added to the photopolymerizable composition and localized on the surface of the light-sensitive layer in the process of drying after the coating. The amount of the higher fatty acid derivative is preferably from about 0.5 to about 10 % based on the total weight of the photopolymerizable composition. Furthermore, a dye or pigment may be added for pigmenting the light-sensitive layer. The amount of the dye or pigment is preferably from about 0.5 to about 5 % based on the total weight of the photopolymerizable composition. Moreover, inorganic fillers and the other known additives may be added for improving physical properties of the cured film.

The photopolymerizable composition of the present invention can be dissolved in various kinds of solvents and then applied onto the surface of a substrate. Examples of the solvents usable herein include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimetyl formamide, dimethylsulfoxide, γ-butyrolactone, methyl lactate and ethyl lactate. These solvents may be used alone or in combination. The concentration of the foregoing components (solid content) in the coating solution is suitably from 2 to 50%.

The coating amount of the photopolymerizable composition is preferably from about 0.1 to about 10 g/m², more preferably from 0.5 to 5 g/m² after drying.

Any dimensionally stable plate-like materials can be used as the substrates. Examples of such dimensionally stable plate-like materials include paper, paper laminated with plastics such as polyethylene, polypropylene or polystyrene, metal plates such as aluminum including alloys of aluminum, zinc and copper plates, plastic films such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate and polyvinyl acetal films, and paper and plastic films laminated or deposited with the foregoing metals. Among these substrates, aluminum plates are particularly preferred because of high dimensional stability and low price. Composite sheets comprising polyethylene terephthalate films on which aluminum sheets are adhered as disclosed in J.P.KOKOKU No. Sho 48-18327 are preferred.

Substrates having the metallic surfaces, particularly the aluminum surfaces are preferably subjected to surface-treatments such as graining, dipping in an aqueous solution of sodium silicate, potassium fluorozirconate or a phosphate and/or anodization.

The aluminum plate treated by dipping in an aqueous solution of sodium silicate after graining can be preferably used. The aluminum plate which is anodized and then dipped in an aqueous solution of an alikali metal silicate as disclosed in J.P.KOKOKU No. Sho 47-5125 can preferably be used. The foregoing anodization treatment is performed by passing an electric current through the aluminum plate serving as an anode in an electrolyte such as an aqueous or non-aqueous solution of an inorganic acid such as phosphoric acid, chromic acid, sulfuric acid or boric acid, an organic acid such as oxalic acid and sulfamic acid, and the mixture thereof.

Silicate electrodeposition as disclosed in U.S.P. No. 3,658,662 is also effective as a surface treatment of the aluminum plates.

The aluminum plates which are subjected to the surface-treatment of the combination of the anodization with the treatment of dipping in a solution of sodium silicate after electrolytic graining as disclosed in J.P.KOKOKU No. Sho 46-27481, and J.P.KOKAI Nos. Sho 52-58602 and Sho 52-30503 can be also used.

The aluminum plates which are in order mechanically surface-roughened, chemically etched, electrolytically grained, anodised and then treated with sodium silicate as disclosed in J.P.KOKAI No. Sho 56-28893 can be also preferably used.

After these treatments, an underlying coating is optionally and preferably applied onto the aluminum plates. Examples of the materials for the underlying coating include water-soluble resins such as polyvinylphosphonic acid, polymers and copolymers having sulfonic groups on the side chains, polyacrylic acid, water-soluble metallic salts such as zinc borate, yellow dyes or amine salts.

These hydrophilization treatments are performed for not only hydrophilizing the surface of the substrates but also preventing any harmful reactions between the substrate and the photopolymerizable composition and improving the adhesion of the light-sensitive layer to the substrate.

A protective layer having high oxygen-barrier properties may optionally be applied onto the layer of the photopolymerizable composition overlaying on the substrate for preventing the polymerization-inhibitory effect of oxygen in the air. Examples of the materials for the protective layer include polyvinyl alcohol, particularly those having a degree of saponification of at least 99 %, and acidic celluloses. The protective layer can be applied by methods described in detail in U.S.P. No. 3,458,311 and J.P.KOKOKU No. Sho 55-49729.

The photopolymerizable composition of the present invention can be used in usual photopolymerization reactions. Furthermore, it can for example be used in various arts of printing plates and photoresists for the preparation of printed circuit boards.

The light-sensitive material obtained from the photopolymerizable composition of the present invention is imagewise exposed to light and then developed with a developer to remove the non-exposed areas of the light-sensitive layer and to thus form images. Preferred examples of the developers used in the preparation of lithographic printing plates using the photopolymerizable composition of the present invention include developers described in J.P.KOKOKU No. 57-7427. Suitable developers are solutions of inorganic alkaline agents such as sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium bicarbonate and aqueous ammonia, and solutions of organic alikaline agents such as monoethanolamine and diethanolamine. The concentration of the alkaline solution is from 0.1 to 10 %, preferably from 0.5 to 5 %.

The alkaline solution may optionally contain a small amount of a surfactant and/or an organic solvent such as benzyl alcohol, 2-phenoxyethanol and 2-butoxyethanol. Specific examples thereof include those disclosed in U.S.P. Nos.3,375,171 and 3,615,480.

The other excellent developers are those disclosed in J.P.KOKAI Nos. Sho 50-26601 and 58-54341, and J.P.KOKOKU Nos. Sho 56-39464 and 56-42860.

The photopolymerizable composition of the present invention has high sensitivity to wide variety of active light extending from ultraviolet to visible light. Therefore, a variety of sources such as ultrahigh pressure, high pressure, intermediate pressure and low pressure mercury lamps, chemical lamps, carbon arc lamps, xenon lamps, metal halide lamps, visible and ultraviolet light laser lamps, fluorescent lightings, tungsten lamps and sunlight can be used as light sources.

The present invention will be explained in more detail with reference to the following non-limiting working examples.

### Preparation Examples

### 1. Preparation of p-(Methylthio)benzonitrile

50 g of p-(methylthio)benzaldehyde (3.28 × 10⁻¹ moles), 26.3 g of hydroxylamine hydrochloride (3.78×10⁻¹ moles, 1.15 equivalent weights), 40.2 g of sodium formate (5.91×10⁻¹ moles, 1.8 equivalent weights), 430 ml of formic acid were charged in a 1 liter evaporation flask and were heated under reflux for 1 hour. After being cooled, the reaction solution was poured into 3.5 liters of water to cause crystallization. The crystals were obtained by filtration, washed with 1 liter of water and transferred into a Petri dish to dry under vacuum. p-(Methylthio)benzonitrile (43.4 g) was obtained at a yield of 88.7 %.

### 2. Preparation of 2-[p-(Methylthio)phenyl]-4,6-bis(trichloromethyl)-1,3,5-triazine

30 g of p-(methylthio)benzonitrile (0.20 moles) and 173.3 g of trichloroacetonitrile (1.20 moles, 6 equivalent weights) were charged in a 300 ml three-necked flask, stirred and cooled in an ice bath. After being cooled sufficiently, 5.33 g of aluminum bromide (0.02 moles, 0.1 equivalent weights) was added to the reaction solution and then hydrochloride gas was fed into the reaction solution for 3 hours. Then the reaction solution was stirred for 2 hours while being cooled, stirred for 6 hours at a room temperature and left to stand over night.

1.2 l of ethyl acetate was added to the reaction solution and the mixture was separated into an aqueous phase and an organic phase after being washed with water four times. The organic phase was dried with magnesium sulfate and concentrated. The concentrate was crystallized from ethanol to obtain 2-[p-(methylthio)phenyl]-4,6-bis(trichloromethyl)-1,3,5-triazine (44.9 g) at a yield of 51 %.

### 3. Preparation of 2-[p-(Methanesulfonyl)phenyl]-4,6-bis(trichloromethyl)-1,3,5-triazine

10 g of 2-[p-(methylthio)phenyl]-4,6-bis(trichloromethyl)-1,3,5-triazine (22.8 millimoles) and 40 ml of a 31 % aqueous hydrogen peroxide were charged in a 200 ml evaporation flask and stirred. 44 g of acetic acid was gradually added to the solution and the mixture was heated under reflux for 1 hour. The reaction solution was cooled to a room temperature to cause crystallization. 50 ml of ethanol was added to the reaction solution to conduct recrystallization. The objective product (8.37 g) having a melting point of from 195 to 197°C was obtained at a yield of 78 %. The objective product has λₘₐₓ ^{THF} of 271 nm (ε =2.42 × 10⁴).

### 4. Preparation of 2-(2,6-Difluorophenyl)-4,6-bis-(trichloromethyl)-1,3,5-triazine

10 g of 2,6-difluorobenzonitrile (71.9 millimoles) and 62.3 g of trichloroacetonitrile (431 millimoles, 6 equivalent weights) were charged in a 200 ml three-necked flask, stirred and cooled in an ice bath. After being cooled sufficiently, 1.92 g of aluminum bromide (7.19 millimoles, 0.1 equivalent weights) was added to the reaction solution and then hydrochloride gas was fed into the reaction solution for 3 hours. Then the reaction solution was stirred for 2 hours while being cooled, stirred for 6 hours at a room temperature and left to stand over night.

Ethyl acetate was added to the reaction solution and the mixture was separated into an aqueous phase and an organic phase after being washed with water four times. The organic phase was dried with magnesium sulfate and concentrated. The concentrate was applied on a column chromatography and eluted with n-hexane. The fractions were concentrated and the concentrate was recrystallized from n-hexane to obtain the objective product (3.2 g) at a yield of 10 %. The objective product has λₘₐₓ ^{THF} of 264 nm (ε =1.25 × 10⁴).

### Examples 1 to 5, and Comparative Examples 1 to 8

An aluminum plate having a thickness of 0.30 mm was grained on the surface with a nylon brush and an aqueous suspension of pumice stone and then sufficiently washed with water. Then the plate was etched by dipping in a 10 % aqueous solution of sodium hydroxide at 70 °C for 60 seconds, followed by washing with running water, neutralization and washing with a 20 % nitric acid solution and washing with water. The aluminum plate thus treated was electrolytically surface-roughened in a 1 % aqueous solution of nitric acid at a V_{A} of 12.7 V using a sinusoiodal alternating waved current in a quantity of electricity at the anode time of 160 coulomb/dm². The surface roughness of the aluminum plate was 0.6 µm expressed in terms of R ₐ unit. Subsequently, the aluminum plate was dipped in a 30 % aqueous solution of sulfuric acid at 50 °C for 2 minutes to desmut the plate and anodized at a current density of 2 A/dm² in a 20 % aqueous solution of sulfuric acid to form an anodized layer having a thickness of 2.7 g/m².

A light-sensitive composition having the following composition was applied onto the aluminum plate thus treated in a coating weight of 1.4 g/m² (weighed after drying) and then dried at 80 °C for 2 minutes.

| | |
|---|---|
| Trimethylolpropane tri(acryloyloxypropyl) ether | 2.0 g |
| Allyl methacrylate/methacrylic acid copolymer (copolymerization molar ratio = 80/20) | 2.0 g |
| Photopolymerization initiator | X g |
| Fluorine atom-containing nonionic surfactant | 0.03 g |
| Methyl ethyl ketone | 20 g |
| Propylene glycol monomethyl ether acetate | 20 g |

A 3 % by weight aqueous solution of a polyvinyl alcohol (degree of saponification :86.5-89 mole %, degree of polymerization : 1000) was applied onto the light-sensitive layer in a coating weight of 2 g/m² (weighed after drying) and then dried at 100 °C for 2 minutes. A test of the sensitivity of the light-sensitive material was conducted using visible light. The visible light was monochromatic light obtained by passing light from a Xenon lamp through a Kenko Optical Filter BP-49.

The sensitivity of the light-sensitive material was determined using Fuji PS Step Guide (available from Fuji Photo Film Co., Ltd.; Step Tablet having 15 steps and a transmission optical density difference between the neighbouring two steps of 0.15, with the initial transmission optical density of 0.05). The sensitivity was expressed in terms of the number of clear steps observed when the light-sensitive layer was exposed to light at an illuminance on the film surface of 0.0132 mW/cm² for 80 seconds. The light-sensitive material was developed with a developer having the following composition at 25 °C for 1 minute after the exposure to light.

| | |
|---|---|
| 1K potassium silicate | 30 g |
| Potassium hydroxide | 15 g |
| C₁₂H₂₅-C₆H₄-O-C₆H₄-SO₃Na | 3 g |
| Water | 1000 g |

The following compounds were used as photopolymerization initiators. The sensitivity of each light sensitive material is shown in the following Table 2.

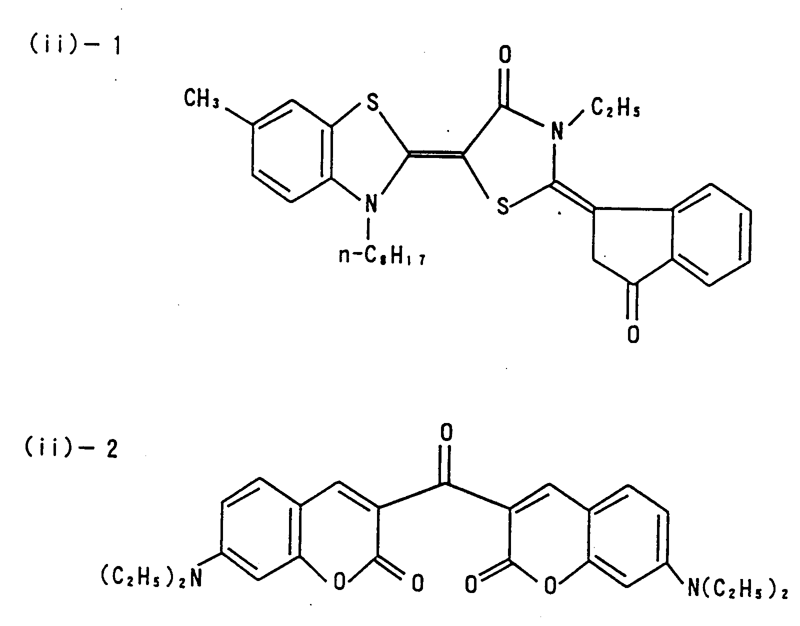

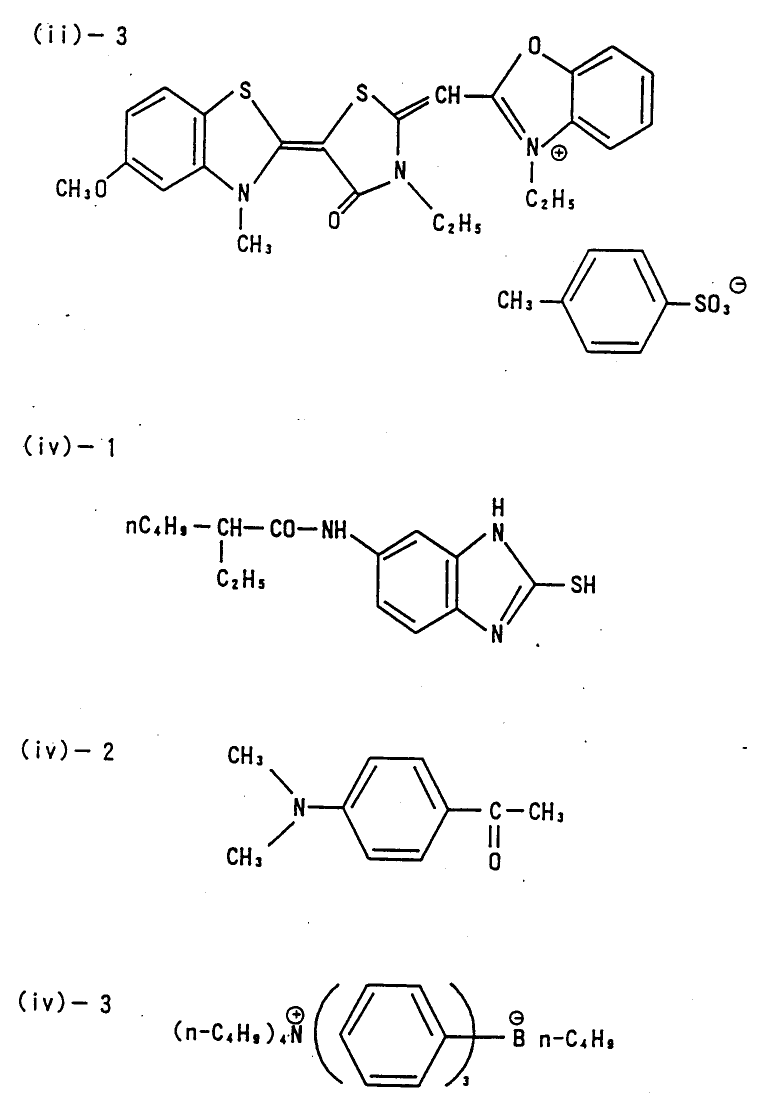

**Table 2**

| Example Number | Polymerization Initiator | | | |
|---|---|---|---|---|
| | Component(ii) (amount:g) | Component(iii) (amount:g) | Component(iv) (amount:g) | Sensitivity (number of clear steps) |
| | | | | |

| Examples | | | | |
|---|---|---|---|---|
| 1 | (ii)-1 (0.1) | (iii)-1 (0.1) | - | 11 |
| 2 | (ii)-2 (0.1) | (iii)-1 (0.1) | - | 8 |
| 3 | (ii)-3 (0.1) | (iii)-1 (0.1) | - | 10.5 |
| 4 | (ii)-1 (0.1) | (iii)-6 (0.1) | - | 11 |
| 5 | (ii)-1 (0.1) | (iii)-5 (0.1) | - | 10.5 |

| Comparative Examples | | | | |
|---|---|---|---|---|
| 1 | (ii)-1 (0.1) | - | - | No image |
| 2 | (ii)-2 (0.1) | - | - | No image |
| 3 | (ii)-3 (0.1) | - | - | No image |
| 4 | (ii)-1 (0.1) | - | (iv)-1 (0.2) | No image |
| 5 | (ii)-1 (0.1) | - | (iv)-2 (0.2) | No image |
| 6 | (ii)-1 (0.1) | - | (iv)-3 (0.2) | No image |
| 7 | - | (iii)-1 (0.1) | - | No image |
| 8 | - | (iii)-1 (0.1) | (iv)-1 (0.2) | No image |

The results shown in Table 2 indicate that the photopolymerizable compositions comprising Components (ii) and (iii) have high sensitivities and that the sensitivities of the photopolymerizable compositions are further improved by the addition of Component (iv).

## Claims

1. A photopolymerizable composition comprising the following compounds (i), (ii) and (iii):
(i) a polymerizable compound having an addition-polymerizable unsaturated bond;
(ii) a sensitizing compound capable of absorbing radiation somewhere within the range of wavelengths between 250 and 1000 nanometers and capable of sensitzing 2-phenyl-4,6-bis(trichloromethyl)-s-triazine;
(iii) a 2,4,6-substituted-1,3,5-triazine compound represented by formula (I) 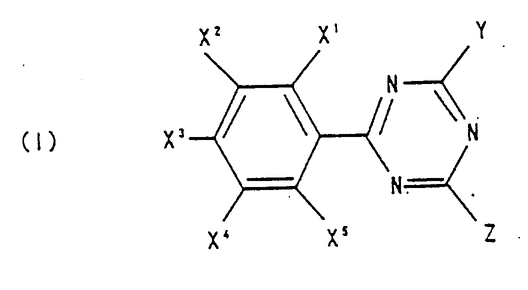 wherein Y and Z are the same or different, and each is an alkyl, substituted alkyl, aryl, substituted aryl, aralkyl or substituted aralkyl group, provided that at least one of them is a mono-, di-, or trihalogen-substituted methyl group,
X¹-X⁵ each is a hydrogen atom or a group having a Hammet's σₘ value of more than 0.40, provided that at least one of them is not a hydrogen atom.

2. The photopolymerizable composition of claim 1, wherein compound (i) is contained in an amount of from 5 to 50% by weight, based on the total weight of the composition.

3. The photopolymerizable composition of claim 1, wherein compound (ii) is at least one compound selected from the group consisting of cyanine dyes, merocyanine dyes, coumarin dyes, ketocoumarin dyes, (thio)xanthene dyes, acridine dyes, thiazole dyes, thiazine dyes, oxazine dyes, azine dyes, aminoketone dyes, squarylium dyes, pyridinium dyes, (thia)pyrylium dyes, porphyrin dyes, triaryl methane dyes, (poly)methine dyes, amino styryl compounds and aromatic polycyclic hydrocarbons.

4. The photopolymerizable composition of claim 1, wherein the composition further contains a linear organic polymer.

5. The photopolymerizable composition of claim 4, wherein the linear organic polymer is contained in an amount of from 30 to 85% by weight, based on the total weight of the composition.

6. The photopolymerizable composition of claim 1, wherein the photopolymerization initiator system consisting of compounds (ii) and (iii) is contained in an amount of from 0.01 to 60% by weight based on the sum of the weight of compound (i) and the weight of the optionally added linear organic polymer.

7. The photopolymerizable composition of claim 1, wherein the composition further contains
(iv) a compound selected from the group consisting of:
(a) compounds having a group of R¹ R² N-
wherein R¹ and R² each ist a hydrogen atom, an alkyl group having from 1 to 18 carbon atoms or a substituted alkyl group having from 1 to 18 carbon atoms with a substituent selected from -OR³, -CO-R³, -CO-C₆H₄-(B)ₙ, -COOR³, -NH-CO-R³, -NH-CO-C₆H₄-(B)ₙ, -(CH₂CH₂O)ₘ-R³ and a halogen atom, wherein R³ is a hydrogen atom or a alkyl group having from 1 to 10 carbon atoms and B is a dialkyl amino group, a hydroxyl group, an acyloxy group, a halogen atom or a nitro group, n is an integer of from 0 to 4, and m is an integer of from 1 to 20;
(b) thio compounds represented by the following general formula (III) 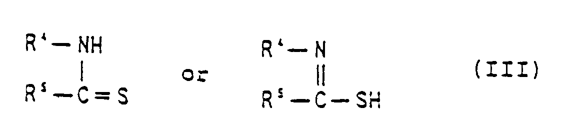 wherein R⁴ is an alkyl group, a substituted alkyl group, an aryl group or a substituted aryl group, R⁵ is a hydrogen atom, an alkyl group, or a substituted alkyl group, and R⁴ and R⁵ may be bonded together to form a non-metal atom group necessery for forming a 5-7 membered ring which may contain a hetero atom selected from oxygen, sulfur and nitrogen atoms,
(c) compounds represented by the following general formula (IV) 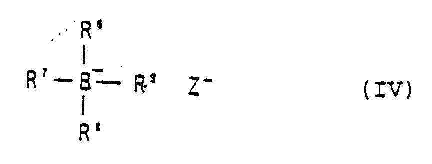 wherein R⁶, R⁷, R⁸ and R⁹ are the same or different, and each is a substituted or unsubstituted alkyl group, a substituted or unsubstituted aryl group, a substituted or unsubstituted alkenyl group, a substituted or unsubstituted alkynyl group, a substituted or unsubstituted heterocyclic group, and at least two of R⁶, R⁷, R⁸ and R⁹ may be bonded together to form a cyclic structure, provided that at least one of R⁶, R⁷, R⁸ and R⁹ is an alkyl group, and Z⁺ represents an alkaline metal cation or a quaternary ammonium cation.

8. The photopolymerizable composition of claim 7, wherein the photopolymerization initiator system consisting of compounds (ii), (iii) and (iv) is contained in an amount of from 0.01 to 60% by weight, based on the sum of the weight of compound (i) and the weight of the optionally added linear organic polymer.

## Patentansprüche

1. Photopolymerisierbare Zusammensetzung, umfassend die folgenden Verbindungen (i), (ii) und (iii):
(i) eine polymerisierbare Verbindung mit einer additionspolymerisierbaren ungesättigten Bindung;
(ii) eine Senisbilisierungsverbindung, die Strahlung irgendwo im Bereich der Wellenlängen zwischen 250 und 1000 Nanometer absorbieren kann und 2-Phenyl-4,6-bis(trichlormethyl)-s-triazin sensibilisieren kann;
(iii) eine 2,4,6-substituierte 1,3,5-Triazinverbindung der Formel (I) 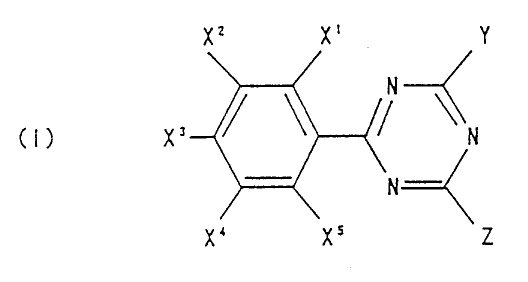 worin Y und Z gleich oder verschieden sein können und jeweils eine Alkyl-, substituierte Alkyl-, Aryl-, substituierte Aryl-, Aralkyl- oder substituierte Aralkylgruppe sind, mit der Maßgabe, daß mindestens eines von Y und Z eine Mono-, Di- oder Trihalogen-substituerte Methylgruppe ist, und
X¹ bis X⁵ jeweils ein Wasserstoffatom oder eine Gruppe mit einem Hammett σₘ-Wert von mehr als 0,40 ist, mit der Maßgabe, daß mindestens eines von X¹ bis X⁵ nicht Wasserstoff ist.

2. Photopolymerisierbare Zusammensetzung nach Anspruch 1, worin die Verbindung (i) in einer Menge von 5 bis 50 Gew.-%, bezogen auf das Gesamtgewicht der Zusammensetzung, enthalten ist.

3. Photopolymerisierbare Zusammensetzung nach Anspuch 1, worin die Verbindung (ii) mindestens eine Verbindung ist, gewählt aus der Gruppe, bestehend aus Cyaninfarbstoffen, Merocyaninfarbstoffen, Cumarinfarbstoffen, Ketocumarinfarbstoffen, (Thio)xanthenfarbstoffen, Acridinfarbstoffen, Thiazolfarbstoffen, Thiazinfarbstoffen, Oxazinfarbstoffen, Azinfarbstoffen, Aminoketonfarbstoffen, Squaryliumfarbstoffen, Pyridiniumfarbstoffen, (Thia)pyryliumfarbstoffen, Porphyrinfarbstoffen, Triarylmethanfarbstoffen, (Poly)methinfarbstoffen, Aminostyrylverbindungen und aromatischen polycyclischen Kohlenwasserstoffen.

4. Photopolymerisierbare Zusammensetzung nach Anspruch 1, wobei die Zusammensetzung außerdem ein lineares organisches Polymer enthält.

5. Photopolymerisierbare Zusammensetzung nach Anspruch 4, worin das lineare organische Polymer in einer Menge von 30 bis 85 Gew.-%, bezogen auf das Gesamtgewicht der Zusammensetzung, enthalten ist.

6. Photopolymerisierbare Zusammensetzung nach Anspruch 1, worin das Photopolymerisations-Initiatorsystem, bestehend aus den Verbindungen (ii) und (iii) in einer Menge von 0,01 bis 60 Gew.-%, basierend auf der Summe des Gewichts der Verbindung (i) und des Gewichts des gegebenenfalls zugesetzten linearen organischen Polymers, enthalten ist.

7. Photopolymerisierbare Zusammensetzung nach Anspruch 1, worin die Zusammensetzung außerdem
(iv) eine Verbindung, gewählt aus der Gruppe, bestehend aus:
(a) Verbindungen mit einer Gruppe R¹R²N-
worin R¹ und R² jeweils ein Wasserstoffatom, eine Alkylgruppe mit 1 bis 18 Kohlenstoffatomen oder eine substituierte Alkylgruppe mit 1 bis 18 Kohlenstoffatomen mit einem Substituenten, gewählt aus -OR³, -CO-R³, -CO-C₆H₄-(B)ₙ, -COOR³, -NH-CO-R³, -NH-COC₆H₄-(B)ₙ, -(CH₂CH₂O)ₘ-R³ und einem Halogenatom, bedeutet und R³ ein Wasserstoffatom oder eine Alkylgruppe mit 1 bis 10 Kohlenstoffatomen und B eine Dialkylaminogruppe, eine Hydroxylgruppe, eine Acyloxygruppe, ein Halogenatom oder eine Nitrogruppe bedeutet, n eine ganze Zahl von 0 bis 4 und m eine ganze Zahl von 1 bis 20 ist;
(b) Thioverbindungen der folgenden allgemeinen Formel (III) 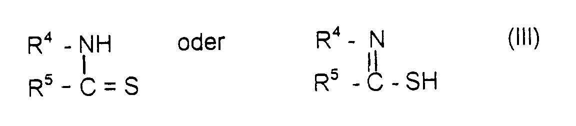 worin R⁴ eine Alkylgruppe, eine substituierte Alkylgruppe, eine Arylgruppe oder eine substituierte Arylgruppe bedeutet, R⁵ ein Wasserstoffatom, eine Alkylgruppe oder eine substituierte Alkylgruppe bedeutet und R⁴ und R⁵ verbunden sein können, um eine Nichtmetall-Atomgruppe zu bilden, die notwendig ist, um einen 5- bis 7-gliedrigen Ring zu erhalten, der ein Heteroatom, gewählt aus Sauerstoff-, Schwefel- und Stickstoffatomen, enthalten kann; und
(c) Verbindungen der folgenden allgemeinen Formel (IV) 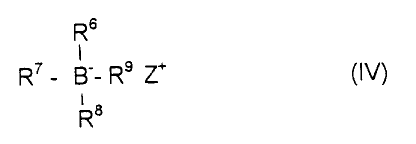 worin R⁶, R⁷, R⁸ und R⁹ gleich oder verschieden sind und jeweils eine substituierte oder unsubstituierte Alkylgruppe, eine substituierte oder unsubstituierte Arylgruppe, eine substituierte oder unsubstituierte Alkenylgruppe, eine substituierte oder unsubstituierte Alkynylgruppe oder eine substituierte oder unsubstituierte heterocyclische Gruppe bedeuten und mindestens zwei von R⁶, R⁷, R⁸ und R⁹ miteinander verbunden sein können, um eine cyclische Struktur zu bilden, mit der Maßgabe, daß mindestens eines von R⁶, R⁷, R⁸ und R⁹ eine Alkylgruppe ist, und Z⁺ ein Alkalimetallkation oder quartäres Ammoniumkation bedeutet;
enthält.

8. Photopolymerisierbare Zusammensetzung nach Anspruch 7, worin das Photopolymerisations-Initiatorsystem, bestehend aus den Verbindungen (ii), (iii) und (iv), in einer Menge von 0,01 bis 60 Gew.-%, basierend auf der Summe des Gewichts der Verbindung (i) und des Gewichts des gegebenenfalls zugesetzten linearen organischen Polymers, enthalten ist.

## Revendications

1. Composition photopolymérisable comprenant les composés (i), (ii) et (iii) suivants :
(i) un composé polymérisable présentant une liaison insaturée polymérisable par addition ;
(ii) un composé sensibilisateur capable d'absorber un rayonnement quelque part dans l'intervalle des longueurs d'onde entre 250 et 1000 nanomètres et capable de sensibiliser la 2-phényl-4,6-bis(trichlorométhyl)-s-triazine ;
(iii) un composé 1,3,5-triazine 2,4,6-substitué représenté par la formule (I) 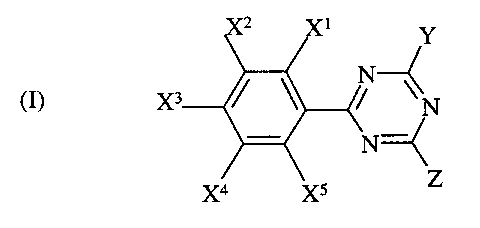 dans laquelle Y et Z sont identiques ou différents et représentant chacun un groupe alkyle, alkyle substitué, aryle, aryle substitué, aralkyle ou aralkyle substitué à condition qu'au moins l'un d'entre eux soit un groupe méthyle mono-, di- ou trihalogène-substitué,
X¹-X⁵ représentent à chaque fois un atome d'hydrogène ou un groupe ayant une valeur de Hammet σₘ supérieure à 0,40 à condition qu'au moins l'un d'entre eux ne soit pas un atome d'hydrogène.

2. Composition photopolymérisable selon la revendication 1, dans laquelle le composé (i) est contenu dans une quantité de 5 à 50 % en poids, rapportés au poids total de la composition.

3. Composition photopolymérisable selon la revendication 1, dans laquelle le composé (ii) est au moins un composé choisi parmi des colorants de cyanine, des colorants de mérocyanine, des colorants de coumarine, des colorants de cétocoumarine, des colorants de (thio)xanthène, des colorants d'acridine, des colorants de thiazole, des colorants de thiazine, des colorants d'oxazine, des colorants d'azine, des colorants d'aminocétone, des colorants de squarylium, des colorants de pyridinium, des colorants de (thia)pyrylium, des colorants de porphyrine, des colorants de triarylméthane, des colorants de (poly)méthine, des composés d'aminostyryle et des hydrocarbures polycycliques aromatiques.

4. Composition photopolymérisable selon la revendication 1, dans laquelle la composition contient en outre un polymère organique linéaire.

5. Composition photopolymérisable selon la revendication 4, dans laquelle le polymère organique linéaire est contenu dans une quantité de 30 à 85 % en poids, rapportés au poids total de la composition.

6. Composition photopolymérisable selon la revendication 1, dans laquelle le système d'initiateur de photopolymérisation constitué des composés (ii) et (iii) est contenu dans une quantité de 0,01 à 60 % en poids, rapportés à la somme du poids du composé (i) et du poids du polymère organique linéaire facultativement ajouté.

7. Composition photopolymérisable selon la revendication 1, dans laquelle la composition contient en outre
(iv) un composé choisi parmi :
(a) des composés présentant un groupe de R¹ R² N-
où R¹ et R² représentent à chaque fois un atome d'hydrogène, un groupe alkyle ayant de 1 à 18 atomes de carbone ou un groupe alkyle substitué ayant de 1 à 18 atomes de carbone avec un substituant choisi parmi -OR³, -CO-R³, -CO-C₆H₄-(B)ₙ, -COOR³, -NH-CO-R³, -NH-CO-C₆H₄-(B)ₙ, -(CH₂CH₂O)ₘ-R³ et un atome d'halogène, où R³ est un atome d'hydrogène ou un groupe alkyle ayant de 1 à 10 atomes de carbone et B est un groupe dialkylamino, un groupe hydroxyle, un groupe acyloxy, un atome d'halogène ou un groupe nitro, n est un nombre entier de 0 à 4 et m est un nombre entier de 1 à 20 ;
(b) des composés thio représentés par la formule générale (III) suivante 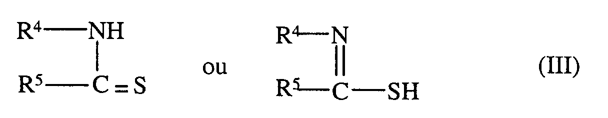 dans laquelle R⁴ est un groupe alkyle, un groupe alkyle substitué, un groupe aryle ou un groupe aryle substitué, R⁵ est un atome d'hydrogène, un groupe alkyle ou un groupe alkyle substitué et R⁴ et R⁵ peuvent être liés pour former un groupe d'atomes de type non-métal nécessaire pour former un cycle à 5-7 éléments qui peut contenir un hétéroatome choisi parmi les atomes d'oxygène, de soufre et d'azote,
(c) des composés représentés par la formule générale (IV) suivante 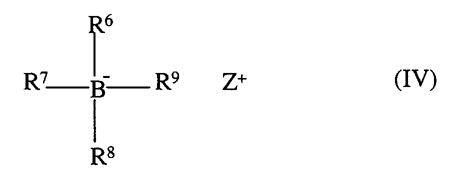 dans laquelle R⁶, R⁷, R⁸ et R⁹ sont identiques ou différents et représentent chacun un groupe alkyle substitué ou non substitué, un groupe aryle substitué ou non substitué, un groupe alcényle substitué ou non substitué, un groupe alkynyle substitué ou non substitué, un groupe hétérocyclique substitué ou non substitué et au moins deux parmi R⁶, R⁷, R⁸ et R⁹ peuvent être liés pour former une structure cyclique à condition qu'au moins l'un parmi R⁶, R⁷, R⁸ et R⁹ soit un groupe alkyle et Z⁺ représente un cation de métal alcalin ou un cation d'ammonium quaternaire.

8. Composition photopolymérisable selon la revendication 7, dans laquelle le système d'initiateur de photopolymérisation constitué des composés (ii), (iii) et (iv) est contenu dans une quantité de 0,01 à 60 % en poids, rapportés à la somme du poids du composé (i) et du poids du polymère organique linéaire facultativement ajouté.
